# EUROPEAN PATENT APPLICATION

(11) **EP 4 826 759 A1**
(43) Date of publication of application: **21.10.2026**
(21) Application number: 26171164.2
(22) Date of filing: 08.04.2026
(51) Int. Cl.: H01J 37/32, H01J 37/34

(54) **ECR PLASMA SOURCE AND METHOD FOR DEPOSITING DOPED THIN FILM ON SUBSTRATE**

(30) Priority: 14.04.2025 CN 202510462052
(71) Applicant: Robert Bosch GmbH, 70442 Stuttgart (DE)
(72) Inventor: TIEDEMANN, Dominik Julian David, Jiangsu, 215021 (CN)

(57) **Abstract**

The present application relates to an ECR plasma source, comprising: a vacuum chamber; an injection device configured to inject a working gas into the vacuum chamber; an emission device configured to emit an electromagnetic wave into a plasma generation region; and a generation device, the generation device comprising: a magnetic field generator generating a static magnetic field in the plasma generation region, the static magnetic field coupling with the electromagnetic wave to ionize the working gas to generate plasma; a body and a cover plate, the body being configured to accommodate the magnetic field generator and the cover plate being configured to cover the body to seal the magnetic field generator relative to the plasma. The ECR plasma source further comprises: a metal target material disposed on an outer surface of at least a portion of the cover plate; a voltage source configured to apply a negative voltage to the cover plate to attract positive ions in the plasma to bombard the metal target material, such that metal atoms in the metal target material are sputtered; and a substrate holding device configured to hold and move a substrate such that a doped film is deposited on the substrate based on the plasma and the metal atoms when the substrate approaches the plasma generation region.

## Description

### TECHNICAL FIELD

The present invention relates to an electron cyclotron resonance (ECR) plasma source and a method for depositing a doped thin film on a substrate using the ECR plasma source.

### BACKGROUND

ECR plasma and magnetron sputtering sources have been widely used in thin film technology. On one hand, the ECR plasma source can be used to deposit a thin film, such as a hydrogenated amorphous carbon film (a-C:H film), on a substrate by a plasma enhanced chemical vapor deposition (PECVD) process. On the other hand, the magnetron sputtering source can be used to deposit a metal-doped film on a substrate by a physical vapor deposition (PVD) process.

### SUMMARY

The present application proposes an improved ECR plasma source and a method for depositing a doped film on a substrate using the ECR plasma source which can deposit a doped film on a substrate with low cost, high efficiency and excellent quality and can be used for forming any metal-doped carbon films with a low metal concentration (for example, a-C:H:Cr doped film) or other metal doped films.

According to one aspect of the present application, there is provided an ECR plasma source, comprising: a vacuum chamber; an injection device configured to inject a working gas into the vacuum chamber; an emission device configured to emit an electromagnetic wave into a plasma generation region in the vacuum chamber; and a generation device. The generation device comprises: a magnetic field generator disposed in the vacuum chamber, the magnetic field generator generating a static magnetic field in the plasma generation region, the static magnetic field coupling with the electromagnetic wave to meet an electron cyclotron resonance condition, thereby ionizing the working gas to generate plasma. The ECR plasma source further comprises: a body and a cover plate, the body being configured to accommodate the magnetic field generator, and the cover plate being configured to cover the body to seal the magnetic field generator relative to the plasma; a metal target material disposed on an outer surface of at least a portion of the cover plate; a voltage source configured to apply a negative voltage to the cover plate to attract positive ions in the plasma to bombard the metal target material, such that metal atoms in the metal target material are sputtered; and a substrate holding device configured to hold and move a substrate such that a doped film is deposited on the substrate based on the plasma and the metal atoms when the substrate approaches the plasma generation region, According to another aspect of the present application, there is provided a method for depositing a doped film on a substrate using the ECR plasma source, the method comprising: activating the injection device to inject the working gas into the vacuum chamber; activating the emission device and the generation device to generate the plasma; activating the voltage source to apply the negative voltage to the cover plate; and causing the substrate held on the substrate holding device to approach the plasma generation region so as to deposit the doped film on the substrate based on plasma and metal atoms.

The ECR plasma source provided in the present application enables active substances in the plasma to be deposited onto the substrate through a PECVD process while simultaneously depositing the metal atoms onto the substrate through a PVD process in one step, without the need for integrating a magnetron sputtering source.

Other features and advantages of the present application will become apparent from the following detailed description of exemplary embodiments of the present application with reference to the accompanying drawings.

### DETAILED DESCRIPTION

The accompanying drawings, which constitute a part of the specification, illustrate embodiments of the present application and, together with the description, serve to explain the principles of the present application.
FIG. 1 is a schematic diagram of an ECR plasma source according to an embodiment of the present application.
FIG. 2 is a schematic perspective view of a portion of a generation device of an ECR plasma source according to an embodiment of the present application.
FIG. 3 is another schematic perspective view of a portion of a generation device of an ECR plasma source according to an embodiment of the present application.
FIG. 4 is another schematic perspective view of a portion of a generation device of an ECR plasma source according to an embodiment of the present application.
FIG. 5 is another schematic perspective view of a portion of a generation device of an ECR plasma source according to an embodiment of the present application.
FIG. 6 is another schematic perspective view of a portion of a generation device of an ECR plasma source according to an embodiment of the present application.
FIG. 7 is another schematic perspective view of a portion of a generation device of an ECR plasma source according to an embodiment of the present application.
FIG. 8 is another schematic perspective view of a portion of a generation device of an ECR plasma source according to an embodiment of the present application.
FIG. 9 is another perspective schematic diagram of a portion of a generation device of an ECR plasma source according to an embodiment of the present application.
FIG. 10 is another schematic perspective view of a portion of a generation device of an ECR plasma source according to an embodiment of the present application.
FIG. 11 is a perspective schematic diagram of a portion of an ECR plasma source according to an embodiment of the present application.
FIG. 12 is another perspective schematic diagram of a portion of an ECR plasma source according to an embodiment of the present application.
FIG. 13 is another perspective schematic diagram of a portion of an ECR plasma source according to an embodiment of the present application.
FIG. 14 is another perspective schematic diagram of a portion of an ECR plasma source according to an embodiment of the present application.
FIG. 15 is another perspective schematic diagram of a portion of an ECR plasma source according to an embodiment of the present application.
FIG. 16 is another schematic diagram of an ECR plasma source according to an embodiment of the present application.
FIG. 17 is another schematic diagram of an ECR plasma source according to an embodiment of the present application.
FIG. 18 is another schematic diagram of an ECR plasma source according to an embodiment of the present application.
FIG. 19 is a perspective schematic diagram of an ECR plasma source according to an embodiment of the present application.

### DETAILED DESCRIPTION

Various exemplary embodiments of the present application will now be described in detail with reference to the accompanying drawings. It should be noted that unless otherwise specifically stated, the relative arrangement of components and steps, numerical expressions and numerical values set forth in these embodiments do not limit the scope of the present application. Techniques and equipment known to ordinary technicians in the relevant art can not be discussed in detail, but where appropriate, the techniques and equipment should be considered part of the specification.

In all examples shown and discussed herein, any specific values should be interpreted as merely exemplary and not limiting. Thus, other examples of the exemplary embodiments can have different values.

It should be noted that like reference numerals and letters refer to similar items in the following figures, and thus, once an item is defined in one figure, it need not be further discussed in subsequent figures.

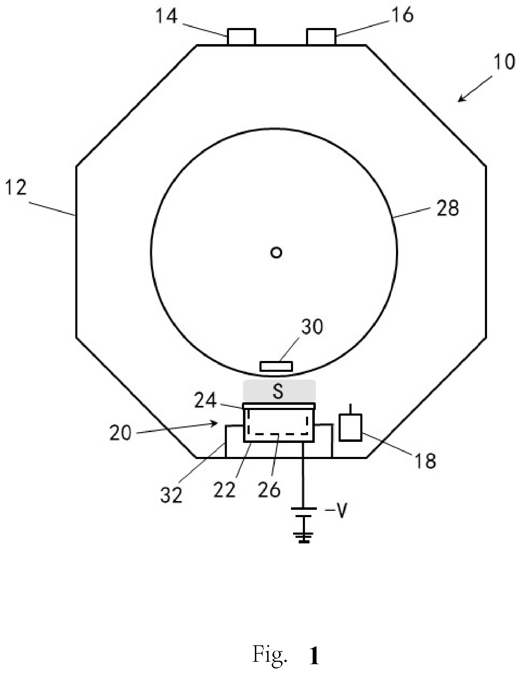

Specific configurations of an example ECR plasma source and an example method for depositing a doped film on a substrate using the example ECR plasma source will be described by using the example ECR plasma source to deposit a metal doped hydrogenated amorphous carbon film (a-C:H:Me film), especially a chromium doped hydrogenated amorphous carbon film (a-C:H:Cr film) on a part, especially a vehicle part. That is, the substrate here can refer to the part or other objects as long as they have a surface on which a doped film is to be deposited. Referring to FIG. 1, the example ECR plasma source 10 comprises: a vacuum chamber 12, which can be evacuated by a vacuum pump 14; and an injection device 16 configured to inject a working gas into the vacuum chamber 12, for example, the working gas can comprise a carrier gas and a reaction gas, wherein the carrier gas is usually an inert gas, has stable chemical properties, is not easy to react with other substances, and can comprise argon (Ar) and helium (He), etc., and the reaction gas can comprise methane (CH₄) or acetylene (C₂H₂), etc. The carrier gas and the reaction gas are usually mixed in a certain proportion, and thus, the injection device 16 can comprise, for example, one or more injection ports leading to the vacuum chamber 12 through a valve.

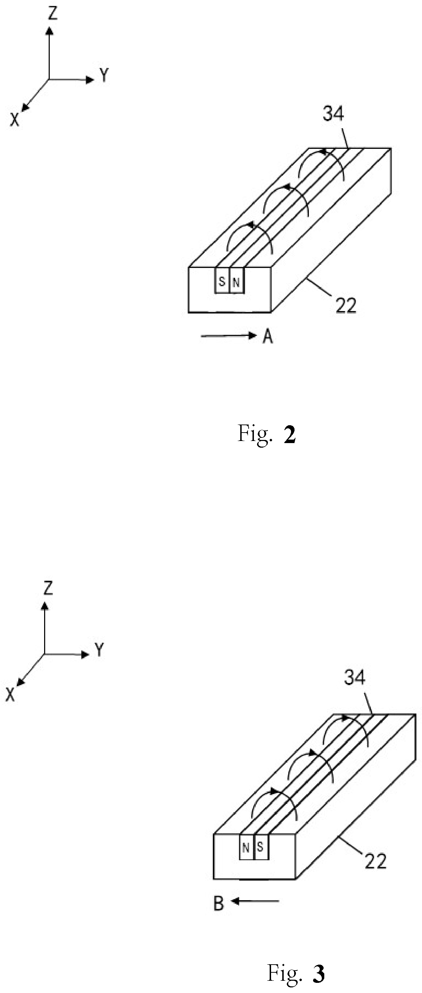

The example ECR plasma source 10 further comprises: an emission device 18 configured to emit an electromagnetic wave into a plasma generation region S in the vacuum chamber 12; and a generation device 20 disposed close to the emission device 18, the generation device 20 disposed in the vacuum chamber 12 and comprising a magnetic field generator including a permanent magnet (as shown in FIGS. 2 to 10) and/or a coil (for example, a DC excitation coil), the permanent magnet generating a static magnetic field in the plasma generation region S, the static magnetic field coupling with the electromagnetic wave to meet an electron cyclotron resonance condition, thereby ionizing the working gas to generate plasma. Specifically, the static magnetic field causes electrons in the vacuum chamber 12 to cyclotron around magnetic flux lines of the static magnetic field, and an electron cyclotron frequency f_{ce} is defined by the following formula: ${f}_{ce} = \frac{eB}{2 {πm}_{e}}$ wherein e is the electron charge, B is the static magnetic field strength, and mₑ is the electron mass.

The emission device 18 can comprise: a waveguide and an optional antenna configured to emit an electromagnetic wave generated by an electromagnetic wave generator, such as a microwave or radio frequency (RF) wave; and a window configured to isolate the vacuum chamber 12 from the waveguide and optional antenna, while allowing the electromagnetic wave to pass through the window. When the frequency of the electromagnetic wave matches the electron cyclotron frequency f_{ce}, the electron cyclotron resonance can be excited, that is, the coupling of the static magnetic field and the electromagnetic wave meets the electron cyclotron resonance condition, whereby the electrons efficiently absorb energy from the electromagnetic wave and are accelerated to a high energy state. The electrons in the high energy state collide with molecules or atoms in the working gas to transfer energy to the working gas, and the working gas is ionized when the energy obtained exceeds its ionization energy to form plasma, and the plasma comprises active substances such as free electrons, positive ions, negative ions, free radicals, excited atoms or molecules, and the active substances in the plasma are further accelerated and confined in the plasma generation region S by the static magnetic field to maintain a stable state of the plasma.

The generation device 20 further comprises a body 22 and a cover plate 24, the body 22 being configured to accommodate the magnetic field generator, and the cover plate 24 being configured to cover the body 22 to seal the magnetic field generator relative to the plasma, that is, to prevent the magnetic field generator from being contaminated by the plasma. For example, the body 22 has a groove 26 (as schematically shown by the dotted line) that basically matches the shape of the magnetic field generator and an open surface leading to the groove 26, the magnetic field generator being inserted in the groove 26 through the open surface, and then the cover plate 24 covering the open surface to close the magnetic field generator. The cover plate 24 can be made of a magnetically transparent (or magnetically permeable) and conductive material. The body 22 can be selectively made of a magnetically transparent material or a magnetically shielding material depending on a specific application.

The example ECR plasma source 10 further comprises: a metal (e.g., Cr) target material, which is disposed, for example, laid on an outer surface of at least a portion of the cover plate 24 that is faced away from the magnetic field generator when the cover plate 24 covers the body 22; and a voltage source configured to apply a negative voltage to the cover plate 24 to attract positive ions in the plasma to bombard the metal target material, such that metal atoms in the metal target material are sputtered into the plasma to be comprised in the plasma. In one case, the voltage source can be directly electrically connected to the cover plate 24, and the body 22 can be non-conductive. In another case, the body 22 can be conductive and electrically connected to the cover plate 24, and thus, the voltage source can also be electrically connected to the body 22.

It should be noted that if the voltage source does not apply the negative voltage to the cover plate 24, the example ECR plasma source 10 can be used as a general ECR plasma source to generate such as an a-C:H thin film through a PECVD process. Here, the concentration of Cr in the a-C:H:Cr doped film is low (for example, at 5% by atomic percentage), and Cr is required to be uniformly dispersed in an a-C:H matrix in the form of metal atoms or nanoparticles, avoiding any chemical reaction with carbon. For this reason, the voltage source applies the negative voltage of an appropriate magnitude to the cover plate 24 to attract the positive ions in the plasma to bombard the metal target material at an appropriate acceleration, such that a proper amount of metal atoms in the metal target material are sputtered into the plasma so as to be physically mixed with the plasma.

The exemplary ECR plasma source 10 further comprises a substrate holding device 28 configured to hold and move a substrate 30 such that a doped thin film is deposited on the substrate 30 based on the plasma and the metal atoms when the substrate 30 approaches the plasma generation region S. That is, the active substances (containing C and H) in the plasma are deposited on the substrate 30 through a PECVD process while simultaneously the metal atoms are deposited on the substrate 30 through a PVD process in one step.

If a magnetron sputtering source is directly combined with a general ECR plasma source to sputter metal atoms in plasma, the metal atoms in the plasma generally have a higher concentration and are easy to chemically react with active substances in the plasma. The combination of the magnetron sputtering source and the general ECR plasma source can generally be used to deposit a chromium carbide film (CrC) on the substrate, but cannot deposit the above-mentioned a-C:H:Cr doped film. In comparison, the example ECR plasma source 10 of the present application is not combined with a magnetron sputtering source, and can be used to deposit the a-C:H:Cr doped film on the substrate 30 with low cost, high efficiency and good quality. It can be understood that the example ECR plasma source 10 can also be used to form any metal doped carbon film or other metal doped films with a lower metal concentration. Optionally, the example ECR plasma source 10 further comprises: a bracket 32, wherein the body 22 is supported in the vacuum chamber 12 by the bracket 32; and a cooling system (not shown), which is directly or indirectly in contact with the cover plate 24 and/or the body 22 via the bracket 32, such that, optionally, the cover plate 24 and/or the body 22 have a high thermal conductivity to help quickly transfer heat generated by sputtering metal atoms from the metal target material to the cooling system.

In the following, various configurations of the magnetic field generator in the form of the permanent magnet will be described in detail. For ease of understanding, an orthogonal coordinate system with an X-axis, Y-axis and Z-axis is shown in FIGS. 2 to 12, wherein the X-axis indicates a length direction of the permanent magnet, the Y-axis indicates a width direction of the permanent magnet, and the Z-axis indicates a height direction of the permanent magnet. That is, the permanent magnet is oriented such that its length direction, width direction, and height directions are perpendicular to each other. Along the length direction, the permanent magnet approaches an origin of the orthogonal coordinate system at its rear and extends away from the origin of the orthogonal coordinate system at its front. Along the width direction, the permanent magnet approaches the origin of the orthogonal coordinate system at its left and extends away from the origin of the orthogonal coordinate system at its right. Along the height direction, the permanent magnet approaches the origin of the orthogonal coordinate system at its base and extends away from the origin of the orthogonal coordinate system at its top. It can be understood that the permanent magnet in FIGS. 2 to 12 can be replaced by or combined with a coil or other types of magnetic field generator.

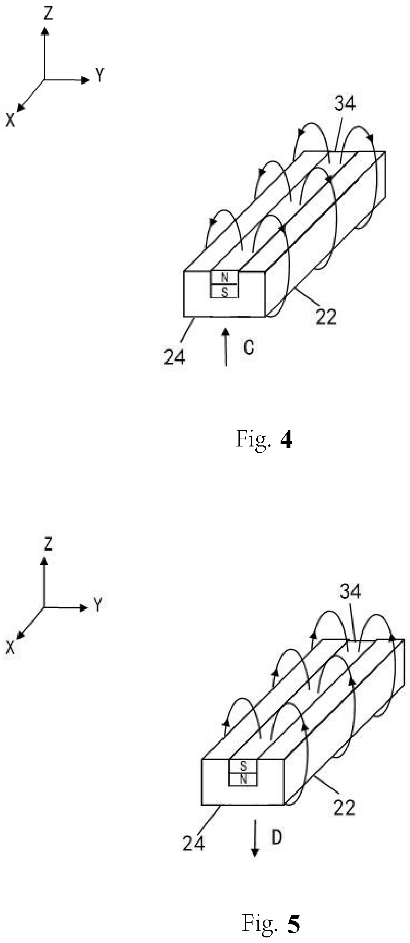

In a first configuration, the permanent magnet can comprise a single permanent magnet strip 34. The single permanent magnet strip 34 has a polarity direction, for example, from its south pole (S) to its north pole (N), oriented along the width direction or the height direction of the permanent magnet. As shown in FIG. 2, the polarity direction of the single permanent magnet strip 34 is represented by an arrow A from left to right in the width direction of the permanent magnet. As shown in FIG. 3, the polarity direction of the single permanent magnet strip 34 is represented by an arrow B from right to left in the width direction of the permanent magnet. As shown in FIG. 4, the polarity direction of the single permanent magnet strip 34 is represented by an arrow C from base to top in the height direction of the permanent magnet. As shown in FIG. 5, the polarity direction of the single permanent magnet strip 34 is represented by an arrow D from top to base in the height direction of the permanent magnet. Thus, the static magnetic field (which can be represented by magnetic flux lines in FIGS. 1 to 5) and hence the plasma is mainly uniformly distributed along the length direction of the permanent magnet. That is, the magnetic field generator is a single piece with its polarity direction oriented along a width direction or a height direction of the magnetic field generator (for example, the single permanent magnet strip 34).

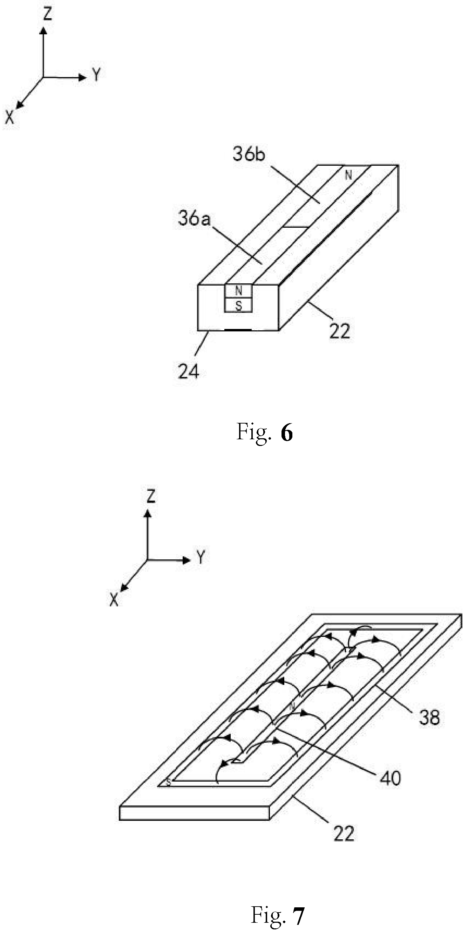

In a second configuration, as shown in FIG. 6, the permanent magnet can comprise a plurality of permanent magnet blocks disposed at intervals, preferably evenly spaced, along the length direction of the permanent magnet. Thus, the groove 26 comprises a plurality of compartments divided, preferably evenly divided, along the length direction of the permanent magnet. The plurality of permanent magnet blocks are inserted in the compartments respectively. The plurality of permanent magnet blocks have polarity directions that can be uniformly oriented along the width direction or the height direction of the permanent magnet. For example, the plurality of permanent magnet blocks comprise a first permanent magnet block 36a and a second permanent magnet block 36b. The polarity direction of the first permanent magnet block 36a is from base to top along the height direction of the permanent magnet. Then, the polarity direction of the second permanent magnet block 36b is from base to top along the height direction of the permanent magnet as well. The first permanent magnet block 36a and the second permanent magnet block 36b can have different shapes and sizes. It should be understood that the static magnetic field (including the strength and position) of the permanent magnet can be adjusted by adding or removing at least one of the first permanent magnet block 36a and the second permanent magnet block 36b. Alternatively or additionally, there can be provided a plurality of first permanent magnet blocks 36a configured to generate different static magnetic fields and a plurality of second permanent magnet blocks 36b configured to generate different static magnetic fields as well. One of the first permanent magnet blocks 36a and one of the second permanent magnet blocks 36b can be selected according to a specific application so as to be inserted into the body 22. That is, the magnetic field generator comprises a plurality of sub magnetic field generators (for example, the plurality of blocks) with their polarity directions uniformly oriented along the width direction or the height direction of the magnetic field generator. In FIGS. 2 to 6, a portion of the cover plate 24 and the body 22 are removed to facilitate the illustration of the permanent magnet.

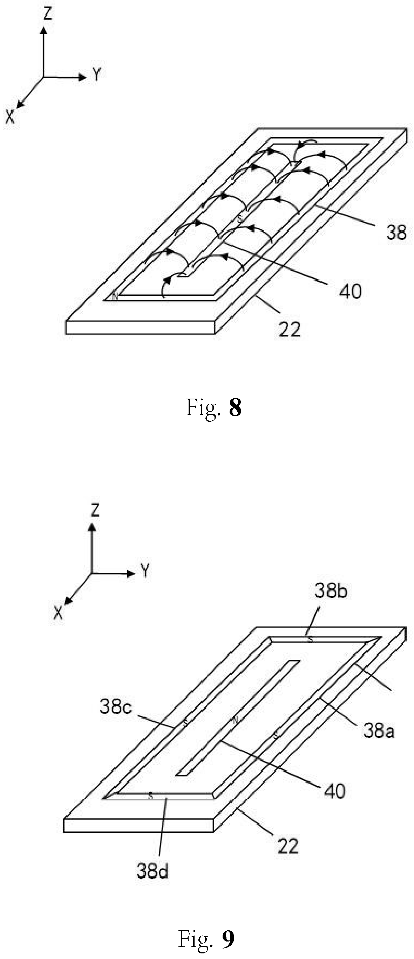

In a third configuration, as shown in FIGS. 7 and 8, the permanent magnet can comprise a permanent magnet ring 38 and a permanent magnet bar 40, for example, disposed centrally in the permanent magnet ring 38. The permanent magnet ring 38 has a first polarity direction are that is disposed along the height direction of the permanent magnet, and the permanent magnet bar 40 has a second polarity direction that is disposed along the height direction of the permanent magnet as well. The first polarity direction is opposite to the second polarity direction. For example, the first polarity direction is from base to top along the height direction of the permanent magnet, while the second polarity direction is from top to base along the height direction of the permanent magnet. Here, the permanent magnet ring 38 is designed in a rectangular shape, with its four sides maintaining a substantially equal distance from the permanent magnet bar 40, such that the static magnetic field and hence the plasma mainly covers the permanent magnet ring 38 and is evenly distributed. It can be understood that the permanent magnet ring 38 can be formed into other closed shapes, such as other types of polygons.

That is, the magnetic field generator comprises a ring-shaped first magnetic field generator (for example, the permanent magnet ring 38) and a second magnetic field generator disposed in the first magnetic field generator (for example, the permanent magnet bar 40), a first polarity direction of the first magnetic field generator and a second polarity direction of the second magnetic field generator being oriented along a height direction of the magnetic field generator, the first polarity direction being opposite to the second polarity direction.

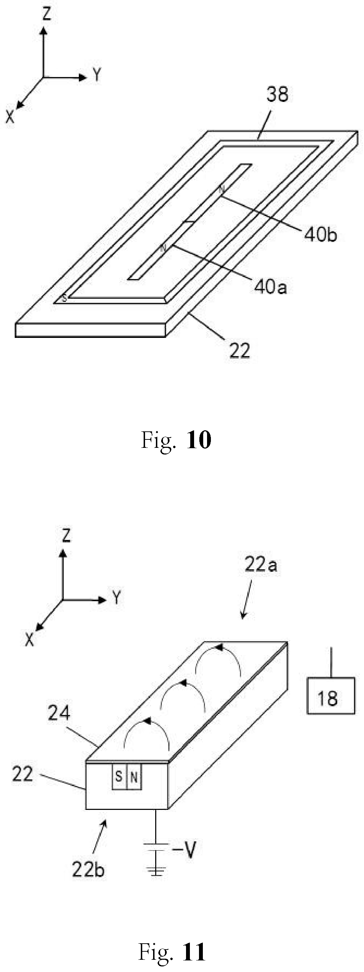

In a fourth configuration, as shown in FIG. 9, the permanent magnet ring 38 is formed by a plurality of first permanent magnet columns 38a, 38b, 38c, and 38d that are disposed at intervals and have polarity directions uniformly oriented along the height direction of the permanent magnet to form the first polarity direction of the permanent magnet ring 38. That is, the first magnetic field generator is formed by a plurality of first sub magnetic field generators (for example, the plurality of first permanent magnet columns) distributed at intervals.In a fifth configuration, as shown in FIG. 10, the permanent magnet bar 40 comprises a plurality of second permanent magnet columns 40a, 40b that are disposed at intervals along the length direction or width direction of the permanent magnet and have polarity directions uniformly oriented along the height direction of the permanent magnet to form the second polarity direction of the permanent magnet bar 40. That is, the second magnetic field generator comprises a plurality of second sub magnetic field generators (for example, the plurality of second permanent magnet columns) distributed at intervals along the length direction or the width direction of the magnetic field generator.

It can be understood that the fourth configuration and the fifth configuration can be used in combination.

The static magnetic field (including the strength and position) of the permanent magnet can be adjusted by adding or removing at least one of the multiple first permanent magnet columns 38a, 38b, 38c, 38d and the multiple second permanent magnet columns 40a, 40b. Alternatively or additionally, there can be provided a plurality of first permanent magnet columns 38a, 38b, 38c, 38d configured to generate different static magnetic fields and a plurality of second permanent magnet columns 40a, 40b configured to generate different static magnetic fields as well. One of the first permanent magnet columns 38a, 38b, 38c, 38d and one of the second permanent magnet columns 40a, 40b can be selected so as to be inserted into the body 22 according to a specific application.

In comparison to the first and second configurations, the third to sixth configurations are capable of producing plasma over a larger volume and achieving higher deposition efficiency. In FIGS. 7 to 10, the cover plate 24 is removed to facilitate the illustration of the permanent magnet.

In the following, various configurations of the cover plate 24 will be described in detail in conjunction with FIGS. 11-15. It can be understood that any of the various configurations of the cover plate 24 can be used in combination with any of the various configurations of the magnetic field generator in the form of the permanent magnet.

As shown in FIG. 11, when the open surface is formed only on a first side 22a (e.g., a top side) of the body 22, the cover plate 24 covers the body 22 on the first side 22a. The static magnetic field generated by the permanent magnet within the body 22 produces magnetic flux lines that propagate into the plasma generation region through the cover plate 24, such that when the emission device 18 emits the electromagnetic wave to the plasma generation region, the plasma is generated on the first side 22a located in the plasma generation region. The body 22A has a second side 22b (e.g., a base side) that is opposite to the first side 22a and covered by a magnetic shielding material (e.g., a metal such as an iron-nickel alloy) to weaken or suppress the static magnetic field on the second side 22b, thereby preventing the plasma to be generated on the second side 22b. Thus, the generation device 20 can generate plasma on a single side.

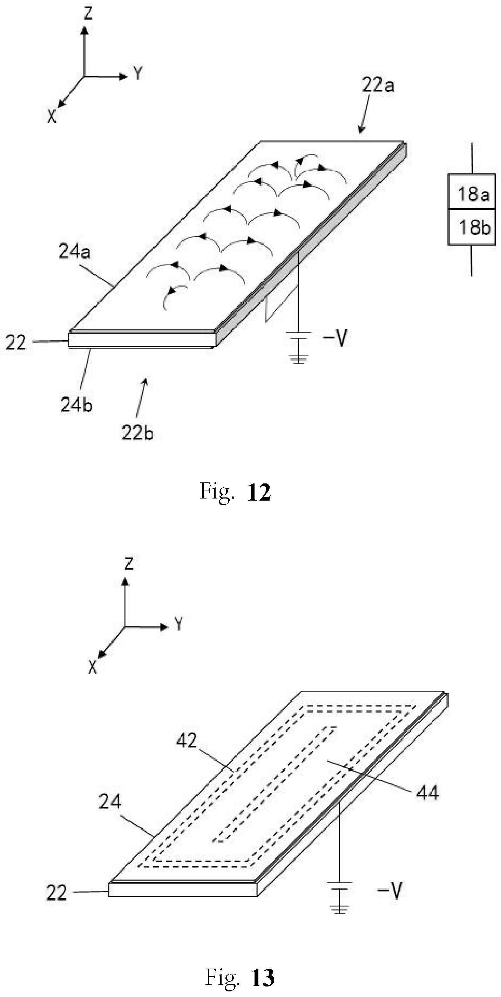

As shown in FIG. 12, when the open surface is formed on the first side 22a and the second side 22b of the body 22, the cover plate 24 is configured to comprise a first cover plate 24a to cover the body 22 on the first side 22a and a second cover plate 24b to cover the body 22 on the second side 22b, and the plasma generation region is configured to comprise a first plasma generation region and a second plasma generation region and the emission device 18 is configured to comprise a first emission device 18a and a second emission device 18b accordingly. The static magnetic field generated by the permanent magnet within the body 22 produces magnetic flux lines that extend through the first cover plate 24a, propagating into the first plasma generation region. These magnetic flux lines continue to advance into the second plasma generation region before passing through the second cover plate 24b and returning to the permanent magnet, completing the magnetic circuit. When the first emission device 18a and the second emission device 18b emit the electromagnetic waves into to the first plasma generation region and the second plasma generation region respectively, the plasma is generated on the first side 22a located in the first plasma generation region and the plasma is generated on the second side 22b located in the second plasma generation region. Thus, the generation device 20 can generate plasma on both sides.

As shown in FIG. 13, when the metal target material is a magnetic shielding material (for example, the metal target material has a high magnetic permeability), the cover plate 24 can comprise a first portion 42 opposed to the groove 26 and a second portion 44 not opposed to the groove 26 when the cover plate 24 covers the body 22, wherein the metal target material is disposed on an outer surface of the second portion 44 so as not to block the magnetic flux lines from propagating through the first portion 42 of the cover plate 24 into the plasma generation region.

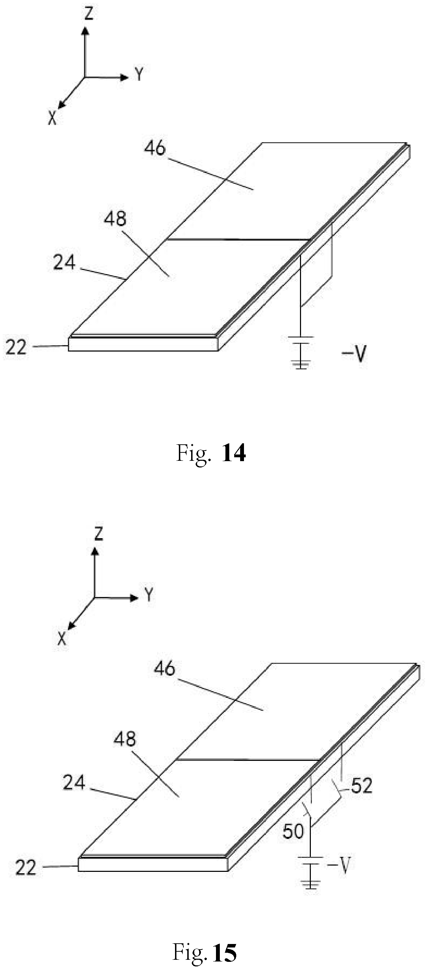

As shown in FIG. 14, optionally, the cover plate 24 comprises at least a first cover plate segment 46 and a second cover plate segment 48 that are electrically isolated from each other, and the metal target material comprises a first metal target disposed on an outer surface of at least a portion of the first cover plate segment 46 and a second metal target disposed on an outer surface of at least a portion of the second cover plate segment 48 accordingly. When the first metal target is the same as the second metal target, the operator can timely replace one of the first metal target and the second metal target that is more consumed. When the first metal target is different from the second metal target, a doped film doped with more than one metal can be deposited on the substrate 30.

Additionally, the voltage source is adapted to apply a negative voltage to at least one of the first cover plate segment 46 and the second cover plate segment 48, such that metal atoms of at least one of the first metal target material and the second metal target material can be sputtered into the plasma. For example, as shown in FIG. 15, the voltage source can be electrically connected to the first cover plate segment 46 via a first switch 50 and electrically connected to the second cover plate segment 48 via a second switch 52. The first switch 50 and the second switch 52 are controlled to be on and off via a controller that controls the various electrical devices of the example ECR plasma source 10, such that at least one of the first cover plate segment 46 and the second cover plate segment 48 is applied with the negative voltage. Thus, especially when the first metal target material is different from the second metal target material, types of the metal atoms sputtered into the plasma can be controlled, whether in a doped film formed in a single step or across multiple deposition steps.

Additionally, the voltage source is adapted to apply a variable negative voltage, such as a higher negative voltage, a lower negative voltage, or a negative voltage that is infinitely variable, to at least one of the first cover plate segment 46 and the second cover plate segment 48, such that metal atoms of at least one of the first metal target material and the second metal target material can be sputtered into the plasma at different concentrations. Thus, especially when the first metal target material is different from the second metal target material, types and concentrations of the metal atoms sputtered into the plasma can be regulated. This regulation can be applied whether in a doped film formed in a single step or across multiple deposition steps, while also enabling the formation of a gradient in the concentration of the metal atoms within the doped film.

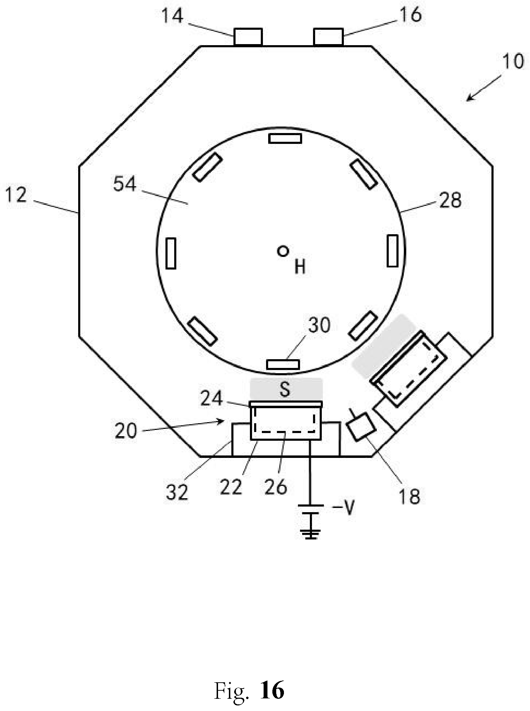

As shown in FIG. 16, the exemplary ECR plasma source 10 can be applied to a batch production system, in which case the substrate holding device 28 can comprise a circular rotatable table 54 that can rotate around a central axis H and comprises a plurality of holders (not shown) uniformly distributed on an outer periphery of the rotatable table 54 along a circumferential direction of the rotatable table 54. A corresponding holder holds a substrate 30 and is optionally rotatable. Additionally, unlike there is one generation device 20 in FIG. 1, there are a plurality of generation devices 20 (for example, two generation devices 20) in FIG. 16 that are disposed outside and close to the outer periphery of the rotatable table 54 along the circumferential direction of the rotatable table 54. The number of emission devices 18 is less than the number of the plurality of generation devices 20. For example, one emission device 18 is provided between the two generation devices 20, and the electromagnetic wave emitted by the one emission device 18 can couple with the static magnetic field generated by the two generation devices 20 to meet the electron cyclotron resonance condition. The number of the plurality of generation devices 20 can be less than the number of the plurality of holders. When the corresponding holder is rotated to approach the plasma generating region and positioned opposite a cover plate 24 of a corresponding generation device 20, the substrate 30 held by the corresponding holder can be deposited with a doped thin film.

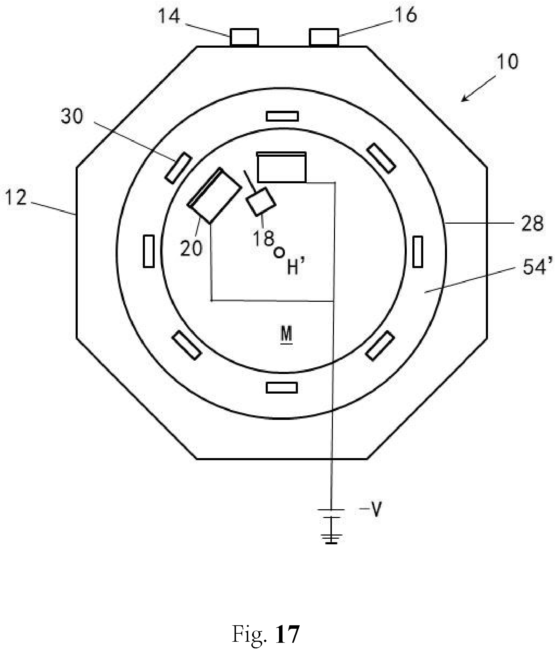

As shown in FIG. 17, the substrate holding device 28 can comprise an annular rotatable table 54' that can rotate around a central axis H'. Similarly, the rotatable table 54' comprises a plurality of holders evenly distributed on an inner periphery of the rotatable table 54' along a circumferential direction of the rotatable table 54'. A corresponding holder holds a substrate 30 and is optionally rotatable. Additionally, one or more generation devices 20 (for example, two generation devices 20) are disposed outside and close to the inner periphery of the rotatable table 54 (that is, in a non rotatable table area M defined by the inner periphery of the rotatable table 54') along the circumferential direction of the rotatable table 54', and an emission device 18 is provided in a manner similar to that shown in FIG. 1 and FIG. 16.

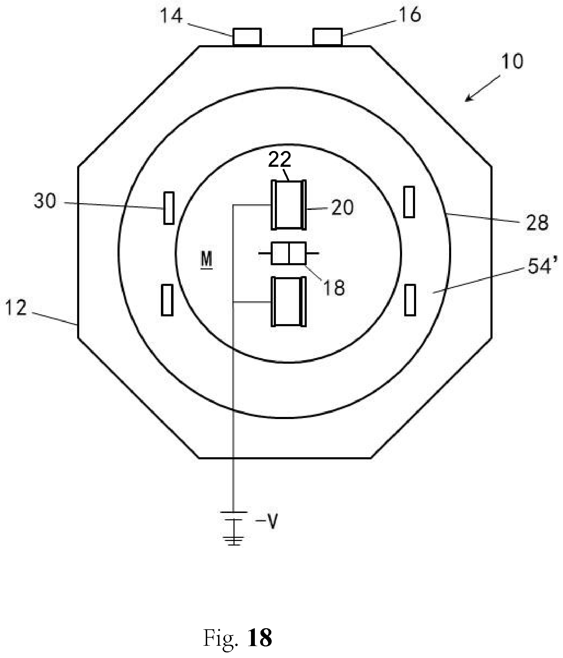

As shown in FIG. 18, the one or more generation devices 20 (for example, two generation devices 20, wherein the two generation devices 20 can generate plasma on both sides) can be disposed outside the inner periphery of the rotatable table 54 along a diameter direction of the rotatable table 54. The number of the emission devices 18 is equal to the number of the generation devices 20. For example, two emission devices 18 are disposed opposite to each other between the two generation devices 20. Specifically, one emission device 18 emits the electromagnetic wave near the first side of the body 22, and the other emission device 18 emits the electromagnetic wave near the second side of the body 22. In this case, a plurality of substrates 30 are disposed on the rotatable table 54 such that the rotatable table 54 can be rotated to position a corresponding substrate 30 opposite one of the first cover plate 24a and the second cover plate 24b.

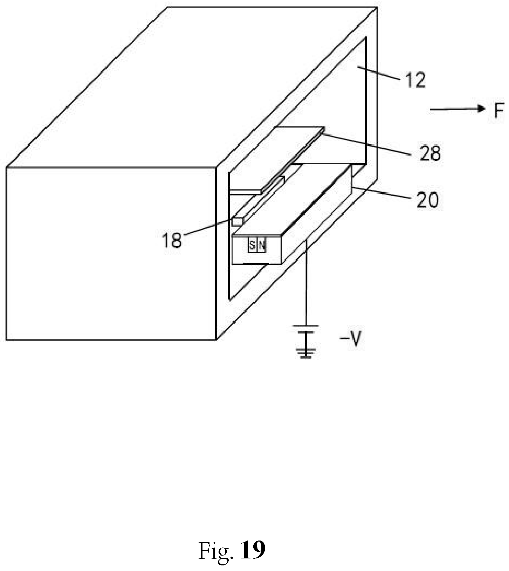

As shown in FIG. 19, the exemplary ECR plasma source 10 can be applied to an online production system, in which case the substrate holding device 28 comprises one or more holders (not shown) to hold one or more substrates 30. The substrate holding device 28 is adapted to move the one or more substrates 30 linearly, i.e., along a straight line (for example, along the width direction of the magnetic field generator, as shown by an arrow F), such that the one or more substrates 30 can sequentially approach and cross the plasma generation region, thereby being "scanned" by the plasma. As a result, the active substances in the plasma are deposited on the one or more substrates 30 through the PECVD process and the metal atoms are deposited on the one or more substrates 30 through the PVD process in one single step. The generation device 20 and the emission device 18 in the online production system can be configured based on the design of the generation device 20 and the emission device 18 in the batch production system.

The method for depositing a doped thin film on a substrate 30 using the exemplary ECR plasma source 10 comprises:
activating the injection device 16 to inject the working gas into the vacuum chamber 12;
activating the emission device 18 and the generation device 20 to generate the plasma;
activating the voltage source to apply the negative voltage to the cover plate 24; and
causing the substrate 30 held on the substrate holding device 28 to approach the plasma generation region S so as to deposit the doped thin film on the substrate 30 based on the plasma and the metal atoms. For example, when the example ECR plasma source 10 is applied to the batch production system, the substrate 30 is caused to be disposed opposite the cover plate 24 (e.g., the first cover plate 24a and the second cover plate 24b) and near the plasma generation region by the rotation of the rotatable table 54, 54'. For example, when the example ECR plasma source 10 is applied to the online production system, the substrate 30 is caused to be disposed opposite the cover plate 24 (e.g., the first cover plate 24a and the second cover plate 24b) and near the plasma generation region by the linear movement of the substrate holding device 28.

When the cover plate 24 comprises the first cover plate segment 46 and the second cover plate segment 48, the step of activating the voltage source to apply the negative voltage to the cover plate 24 comprises: based on a specific application, applying a negative voltage, preferably a variable negative voltage, to at least one of the first cover plate segment 46 and the second cover plate segment 48, such that metal atoms of at least one of the first metal target material and the second metal target material can be sputtered into the plasma.

Here, the steps of the method are only used to clearly illustrate the implementation process of the method and do not constitute a limitation on the order in which the steps are executed.

Unless it is clearly stated that there is a logical or technical dependency between certain steps, it can be understood by those skilled in the art that the order in which these steps are executed can be adjusted, exchanged or performed simultaneously according to actual needs. For example, certain steps can be executed in parallel or in different orders without departing from the core idea and technical scope of the present invention. Thus, any reasonable variation or adjustment of the method steps described in this specification should be deemed to fall within the scope of protection of the present invention.

Although some specific embodiments of the present application have been described in detail by way of example, it should be understood by those skilled in the art that the above examples are only for illustration, not for limiting the scope of the present application. It should be understood by those skilled in the art that the above embodiments can be modified without departing from the scope and spirit of the present application. The scope of the present application is defined by the appended claims.

## Claims

1. An ECR plasma source (10), comprising:
a vacuum chamber (12);
an injection device (16) configured to inject a working gas into the vacuum chamber (12);
an emission device (18) configured to emit an electromagnetic wave into a plasma generation region (S) in the vacuum chamber (12);
a generation device (20), comprising:
a magnetic field generator disposed in the vacuum chamber (12), the magnetic field generator generating a static magnetic field in the plasma generation region (S), the static magnetic field coupling with the electromagnetic wave to meet an electron cyclotron resonance condition, thereby ionizing the working gas to generate plasma;
a body (22) and a cover plate (24), the body (22) being configured to accommodate the magnetic field generator, and the cover plate (24) being configured to cover the body (22) to seal the magnetic field generator relative to the plasma;
a metal target material disposed on an outer surface of at least a portion of the cover plate (24);
a voltage source configured to apply a negative voltage to the cover plate (24) to attract positive ions in the plasma to bombard the metal target material, such that metal atoms in the metal target material are sputtered; and
a substrate holding device (28) configured to hold and move a substrate (30) such that a doped thin film is deposited on the substrate (30) based on the plasma and the metal atoms when the substrate (30) approaches the plasma generation region (S).

2. The ECR plasma source (10) of claim 1, wherein the magnetic field generator is configured as a permanent magnet or a coil.

3. The ECR plasma source (10) of claim 1 or 2, wherein the magnetic field generator is a single piece with its polarity direction oriented along a width direction or a height direction of the magnetic field generator; or
the magnetic field generator comprises a plurality of sub magnetic field generators with their polarity directions uniformly oriented along the width direction or the height direction of the magnetic field generator.

4. The ECR plasma source (10) of claim 1 or 2, wherein the magnetic field generator comprises a ring-shaped first magnetic field generator and a second magnetic field generator disposed in the first magnetic field generator, a first polarity direction of the first magnetic field generator and a second polarity direction of the second magnetic field generator being oriented along a height direction of the magnetic field generator, the first polarity direction being opposite to the second polarity direction.

5. The ECR plasma source (10) of claim 4, wherein the first magnetic field generator is a single piece or is formed by a plurality of first sub magnetic field generators distributed at intervals, and
the second magnetic field generator is a single piece or comprises a plurality of second sub magnetic field generators distributed at intervals along the length direction or the width direction of the magnetic field generator.

6. The ECR plasma source (10) of any one of claims 1 to 5, wherein the body (22) has a groove (26) that matches the shape of the magnetic field generator, and the cover plate (24) comprises a first portion (42) that is opposed to the groove (26) and a second portion (44) that is not opposed to the groove (26) when the cover plate (24) covers the body (22), and wherein the metal target material is disposed on the outer surface of the second portion (44).

7. The ECR plasma source (10) of claim 6, wherein the body (22) has an open surface leading to the groove (26), the magnetic field generator being inserted into the groove (26) through the open surface and the cover plate (24) covering the open surface to seal the magnetic field generator relative to the plasma, and optionally, the open surface is formed on at least one of a first side (22a) and a second side (22b) of the body (22), the first side (22a) being opposite to the second side (22b).

8. The ECR plasma source (10) of any one of claims 1 to 7, wherein at least one of the body (22) and the cover plate (24) has a high thermal conductivity.

9. The ECR plasma source (10) of any one of claims 1 to 8, wherein the substrate holding device (28) is adapted to move the substrate (30) linearly; or
the substrate holding device (28) comprises a rotatable table (54, 54'), a plurality of substrates (30) being disposed on the rotatable table (54, 54'), and one or more generation devices (20) and one or more emission devices (18) being disposed outside and close to the rotatable table (54, 54').

10. The ECR plasma source (10) of claim 9, wherein the rotatable table (54, 54') is a circular rotatable table, the plurality of substrates (30) being disposed on an outer periphery of the rotatable table, and the one or more generation devices (20) and the one or more emission devices (18) being disposed outside and close to the outer periphery of the rotatable table along a circumferential direction of the rotatable table; or
the rotatable table (54, 54') is an annular rotatable table, the plurality of substrates (30) being disposed on an inner periphery of the rotatable table, and the one or more generation devices (20) and the one or more emission devices (18) being disposed outside and close to the inner periphery of the rotatable table along the circumferential direction of the rotatable table or a diameter direction of the rotatable table.

11. The ECR plasma source (10) of any one of claims 1 to 10, wherein the cover plate (24) comprises at least a first cover plate segment (46) and a second cover plate segment (48) electrically isolated from each other, and the metal target comprises a first metal target and a second metal target, the first metal target being disposed on an outer surface of at least a portion of the first cover plate segment (46), and the second metal target being disposed on an outer surface of at least a portion of the second cover plate segment (48).

12. The ECR plasma source (10) of claim 11, wherein the voltage source is adapted to apply a negative voltage, preferably a variable negative voltage, to at least one of the first cover plate segment (46) and the second cover plate segment (48), such that metal atoms of at least one of the first metal target material and the second metal target material can be sputtered into the plasma.

13. A method for depositing a doped thin film on a substrate (30) using the ECR plasma source according to any one of claims 1 to 10, comprising:
activating the injection device (16) to inject the working gas into the vacuum chamber (12);
activating the emission device (18) and the generation device (20) to generate the plasma;
activating the voltage source to apply the negative voltage to the cover plate (24); and
causing the substrate (30) held on the substrate holding device (28) to approach the plasma generation region (S) so as to deposit the doped thin film on the substrate (30) based on the plasma and the metal atoms.

14. The method of claim 13, wherein the cover plate (24) comprises at least a first cover plate segment (46) and a second cover plate segment (48) which are electrically isolated from each other, and the metal target comprises a first metal target and a second metal target, the first metal target being disposed on an outer surface of at least a portion of the first cover plate segment (46), and the second metal target being disposed on an outer surface of at least a portion of the second cover plate segment (48), and the step of activating the voltage source to apply the negative voltage to the cover plate (24) comprises:
applying a negative voltage, preferably a variable negative voltage, to at least one of the first cover plate segment (46) and the second cover plate segment (48), such that metal atoms of at least one of the first metal target and the second metal target can be sputtered into the plasma.
